# EUROPÄISCHE PATENTANMELDUNG

(11) **EP 1 109 433 A2**
(43) Veröffentlichungstag der Anmeldung: **20.06.2001**
(21) Anmeldenummer: 00125886.2
(22) Anmeldetag: 27.11.2000
(51) Int. Cl.: H05K 9/00

(54) **Verfahren zum Herstellen und Aufbringen eines Abschirmprofils**

(30) Priorität: 18.12.1999 DE 19961187
(71) Anmelder: Siegfried Schaal Metallveredelung GmbH & Co., 72517 Sigmaringendorf (DE)
(72) Erfinder: Schaal, Gerhard, 72517 Sigmaringendorf (DE); Korn-Amann, Klaus-Dieter, 72488 Sigmaringen (DE)
(74) Vertreter: Ostertag, Ulrich, Dr.

(57) **Zusammenfassung**

Bei der Herstellung eines Abschirmprofils aus einem elastischen und elektrisch leitfähigen Dichtungsmaterial für ein Gehäuse (5), welches zur Aufnahme elektrischer Funktionselemente bestimmt ist, wird folgendermaßen vorgegangen: In einem ersten Verfahrensschritt wird das Dichtungsmaterial (4) in den nutförmigen Formhohlraum (2) einer Negativform (1) eingebracht. Der Formhohlraum (2) entspricht in seinem Verlauf und in seinem Querschnitt dem Verlauf und dem Querschnitt des herzustellenden Abschirmprofiles. Das Dichtungsmaterial (4) steht zunächst etwas über den Formhohlraum (2) über. Wird nunmehr in einem zweiten Verfahrensschritt das mit dem Abschirmprofil zu versehende Gehäuse (5) in entsprechender Orientierung auf die Negativform (1) aufgesetzt, drücken die mit dem Abschirmprofil zu versehenden Flächen des Gehäuses (5) den überstehenden Bereich des Dichtungsmaterials (4) unter entsprechender Kontaktaufnahme in den Formhohlraum (2) zurück. In dieser Position wird im dritten Verfahrensschritt das Gehäuse (5) auf der Negativform (1) fixiert, bis das Dichtungsmaterial (4) ausreichend ausgehärtet ist. Dann kann das Gehäuse (5) mit anhaftendem Abschirmprofil (4) von der Negativform (1) abgenommen werden.

## Beschreibung

Die Erfindung betrifft ein Verfahren zum Herstellen und Aufbringen eines Abschirmprofils aus einem elastischen und elektrisch leitfähigen Dichtungsmaterial, bei dem dieses auf einen Abschnitt eines Gehäuseteiles für elektrische Funktionselemente, insbesondere auf einen Gehäuseabschnitt eines Funktelefons, in pastösem Zustand aufgebracht wird und dort aushärtet.

Ein solches Verfahren ist aus der DE-U-94 04 291 bekannt. Hier wird das Dichtungsmaterial direkt auf die mit dem Abschirmprofil zu versehenden Flächen des Gehäuses aufgebracht. Dies geschieht mit Hilfe einer Dispensernadel, welche, von einem Roboterarm geführt, entlang der Kontur des herzustellenden Abschirmprofils geführt wird. Due Querschnittsform des sich ergebenden Abschirmprofils stellt sich im wesentlichen entsprechend der Viskosität und den Benetzungseigenschaften des Dichtungsmaterials im Zusammenwirken mit der pro Zeiteinheit aufgebrachten Menge und der Vorschubgeschwindigkeit der Dispensernadel ein. Soll das Abschirmprofil einen sich nicht "automatisch" einstellenden Querschnitt aufweisen, muß die Dispensernadel mehrfach jeweils unter Abgabe einer Raupe auf demselben Wege geführt werden.

In vielen Fällen ist es jedoch wichtig, dem Abschirmprofil eine definierte Querschnittsfläche zu geben: Zur Erzielung der erforderlichen Leitfähigkeit ist eine gewisse Kompression des Dichtungsmaterials notwendig. Damit zu dieser Kompression des Dichtungsmaterials keine zu hohen Kräfte notwendig werden, sollte die Querschnittsfläche des Abschirmprofiles entsprechend ausgestaltet sein.

Aufgabe der vorliegenden Erfindung ist es, ein Verfahren der eingangs genannten Art so auszugestalten, daß sich mit einfachen Mitteln definierte Querschnitte des Abschirmprofiles erreichen lassen.

Diese Aufgabe wird erfindungsgemäß dadurch gelöst, daß
a) in einem ersten Verfahrensschritt das Dichtungsmaterial in einen nutförmigen Formhohlraum einer Negativform eingebracht wird, dessen Verlauf und Querschnitt dem Verlauf und Querschnitt des an dem Gehäuse anzubringenden Abschirmprofils entspricht, wobei das eingebrachte Dichtungsmaterial bereichsweise über den Formhohlraum hinausragt;
b) in einem zweiten Verfahrensschritt die mit dem Abschirmprofil zu versehenden Flächen des Gehäuses so auf das in dem Formhohlraum befindliche Dichtungsmaterial aufgesetzt werden, daß der überstehende Bereich des Dichtungsmaterials im Kontakt mit diesen Flächen in den Formhohlraum zurückgedrückt wird;
c) das Gehäuse solange auf der Negativform fixiert wird, bis das Dichtungsmaterial ausreichend ausgehärtet ist;
d) das Gehäuse mit anhaftendem Abschirmprofil von der Negativform abgenommen wird.

Durch die erfindungsgemäße Verwendung der Negativform läßt sich in äußerst präziser Weise jeder gewünschte Querschnitt des Abschirmprofils (sofern er nur entformbar ist) herstellen. Insbesondere lassen sich Querschnitte von Abschirmprofilen erreichen, die mit sehr geringen Kräften so weit komprimiert werden können, wie dies zur Erzielung der gewünschten Leitfähigkeit erforderlich ist. Ähnlich wie bei dem eingangs erwähnten, aus der DE-U-94 04 291 bekannten Verfahren muß jedoch das Abschirmprofil nicht in einem gesonderten Arbeitsgang auf das Gehäuse als loses Teil aufgelegt oder an diesem befestigt, z.B. angeklebt, werden sondern es entsteht durch Aushärten direkt "in situ" am Gehäuse. Das erfindungsgemäße Verfahren ist daher herstellungstechnisch nahezu ebenso günstig wie das erwähnte bekannte Verfahren.

Zweckmäßigerweise wird das Aushärten des Dichtungsmaterials durch Beheizen beschleunigt. Hierzu empfiehlt es sich wiederum, daß die Negativform beheizt wird. Dies kann z.B. dadurch geschehen, daß die Negativform von Heizkanälen durchzogen ist, die von einem entsprechend temperierten Heizmedium, z.B. heißem Wasser oder Dampf, durchströmt werden.

Vorteilhaftererweise wird der Formhohlraum der Negativform mit Hilfe einer Dispensernadel mit Dichtungsmaterial gefüllt, die entlang des Verlaufes des Formhohlraumes geführt wird. Hierdurch läßt sich das Dichtungsmaterial besonders gut so dosieren, daß es in der gewünschten Weise den Formhohlraum ausfüllt.

Alternativ ist es jedoch auch möglich, den Formhohlraum der Negativform mit Hilfe eines Rakels mit Dichtungsmaterial anzufüllen.

Ein Ausführungsbeispiel der Erfindung wird nachfolgend anhand der Zeichnung näher erläutert; es zeigen
- Figur 1:: schematisch, wie in einem ersten Verfahrensschritt das elastische und leitfähige Dichtungsmaterial in den Formhohlraum einer Negativform eingebracht wird;
- Figur 2:: wie in einem zweiten Verfahrensschritt das mit dem Abschirmprofil zu versehende Gehäuse auf die Negativform aufgesetzt wird;
- Figur 3:: das fertiggestellte, mit Abschirmprofil versehene Gehäuse.

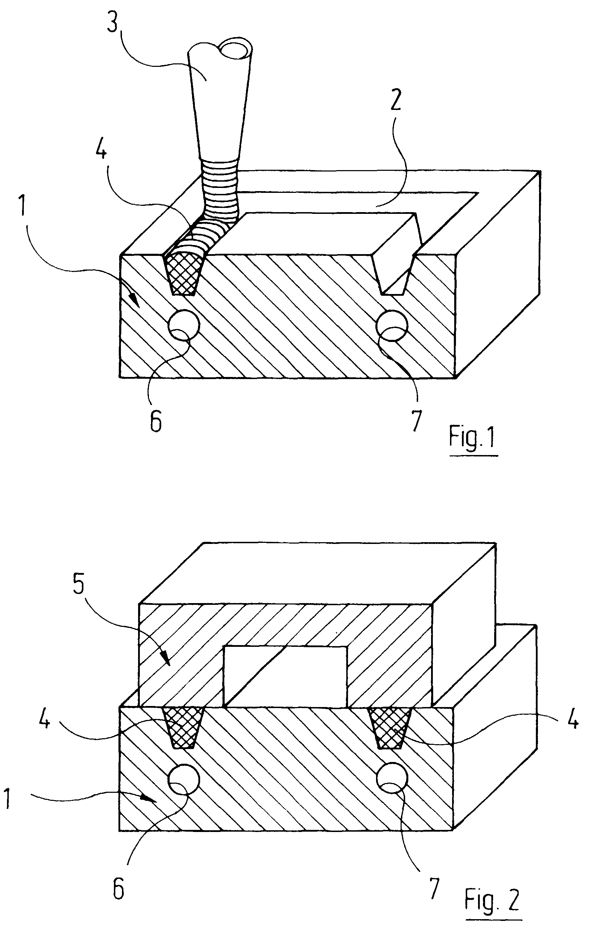

Zunächst wird auf Figur 1 Bezug genommen. In dieser ist im schnitt eine Negativform 1 zu erkennen, in deren obere Stirnfläche ein nutartiger Formhohlraum 2 eingearbeitet ist. Der Formhohlraum 2 erstreckt sich entlang einer Kontur, die dem Verlauf der Wand des mit dem Abschirmprofil zu versehenden Gehäuses entspricht. Die Querschnttsform des Formhohlraumes 2 entspricht komplementär dem Profil des zu schaffenden Abschirmprofils.

In dem in Figur 1 dargestellten ersten Verfahrensschritt wird der Formhohlraum 2 mit einer Dispensernadel 3 mit Dichtungsmaterial 4 in einer solchen Menge gefüllt, daß das eingebrachte Dichtungsmaterial 4 nach dem Glattstreichen den nutförmigen Formhohlraum 2 vollständig ausfüllt. Aufgrund der Oberflächenspannung entsteht beim Einbringen des Dichtungsmaterials 4 allerdings zunächst eine Raupe, die von oben gesehen eine konvexe Fläche aufweist. Diese konvexe Fläche ragt in der Mitte des Formhohlraumes 2 über die entsprechende Stirnfläche der Negativform 1 über, während sie an den Rändern unter dieser Stirnfläche bleibt.

Wenn auf die in Figur 1 gezeigte Weise der gesamte nutförmige Formhohlraum 2 mit Dichtungsmaterial 4 angefüllt ist, wird das mit dem Abschirmprofil zu versehende Gehäuse 5 so mit den Stirnflächen der Wände, welche das Abschirmprofil tragen sollen, nach unten auf die im Formhohlraum 2 befindliche Raupe aus Dichtungsmaterial 4 gedrückt, daß die zuvor noch konvexe, nach oben zeigende Seite dieser Raupe flachgedrückt wird, nunmehr die Stirnfläche der Wand des Gehäuses 5 berührt und den gesamten Profilquerschnitt des Formhohlraumes 2 ausfüllt. Selbstverständlich ist zu diesem Zeitpunkt das Dichtungsmaterial 4 noch nicht ausgehärtet.

Das Gehäuse 5 wird in dieser in Figur 2 dargestellten Position auf der Negativform 1 fixiert und bleibt dort, bis das Dichtungsmaterial 4 unter Anhaften an der Stirnfläche der Gehäusewände ausreichend ausgehärtet ist. Die Zeit, die hierfür benötigt wird, kann durch Beheizen der gesamten Anordnung reduziert werden. Beim in der Zeichnung dargestellten Ausführungsbeispiel besitzt hierzu die Negativform 1 Heizkanäle 6, 7, durch welche ein geeignet temperiertes Heizfluid geführt wird. Dabei kann es sich z.B. um heißes Wasser oder Dampf handeln.

Nach dem Aushärten des Dichtungsmateriales 4 kann das Gehäuse 5 von der Negativform 1 abgehoben werden. Das nunmehr zum Abschirmprofil 4 gewordene Dichtungsmaterial löst sich dabei von der Negativform 1, was durch eine entsprechende, in der Zeichnung nicht dargestellte Auskleidung des Formhohlraumes 2 unterstützt werden kann. Auch Entformungsschrägen an dem Abschirmprofil 4 erleichtern das Abnehmen des Gehäuses 5.

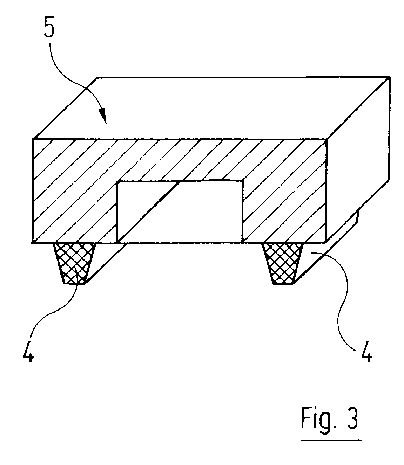

Als Ergebnis entsteht das in Figur 3 dargestellte Gehäuse 5, das an den Stirnflächen seiner Wände mit einem Abschirmprofil 4 des gewünschten, präzisen Querschnittes versehen ist.

Die Negativform 1, die bei dem geschilderten Verfahren eingesetzt wird, kann aus einem Metallwerkstoff bestehen. Es kann hierfür jedoch auch eine ausgeformte Folie oder ein Kunststoffkorpus verwendet werden.

## Patentansprüche

1. Verfahren zum Herstellen und Aufbringen eines Abschirmprofiles aus einem elastischen und elektrisch leitfähigen Dichtungsmaterial, bei dem dieses auf einen Abschnitt eines Gehäuseteiles für elektrische Funktionselemente, insbesondere auf einen Gehäuseabschnitt eines Funktelefons, in pastösem Zustand aufgebracht wird und dort aushärtet,
dadurch gekennzeichnet, daß
a) in einem ersten Verfahrensschritt das Dichtungsmaterial (4) in einen nutförmigen Formhohlraum (2) einer Negativform (1) eingebracht wird, dessen Verlauf und Querschnitt dem Verlauf und dem Querschnitt des an dem Gehäuse (5) anzubringenden Abschirmprofils entspricht, wobei das eingebrachte Dichtungsmaterial (4) bereichsweise etwas über den Formhohlraum (2) hinausragt;
b) in einem zweiten Verfahrensschritt die mit dem Abschirmprofil zu versehenden Flächen des Gehäuses (5) so auf das in dem Formhohlraum (2) befindliche Dichtungsmaterial (4) aufgesetzt wird, daß der überstehende Bereich des Dichtungsmaterials (4) im Kontakt mit diesen Flächen in den Formhohlraum (2) zurückgedrückt wird;
c) das Gehäuse (5) solange auf der Negativform (1) fixiert wird, bis das Dichtungsmaterial (4) ausreichend ausgehärtet ist;
d) das Gehäuse (5) mit anhaftender Abschirmdichtung (4) von der Negativform (1) abgenommen wird.

2. Verfahren nach Anspruch 1, dadurch gekennzeichnet, daß das Aushärten des Dichtungsmaterials (4) durch Beheizen beschleunigt wird.

3. Verfahren nach Anspruch 2, dadurch gekennzeichnet, daß die Negativform (1) beheizt wird.

4. Verfahren nach einem der vorhergehenden Ansprüche, dadurch gekennzeichnet, daß der Formhohlraum (2) der Negativform (1) mit Hilfe einer Dispensernadel (3) mit Dichtungsmaterial (4) gefüllt wird, die entlang des Verlaufes des Formhohlraumes (2) geführt wird.

5. Verfahren nach einem der Ansprüche 1 bis 3, dadurch gekennzeichnet, daß der Formhohlraum (2) der Negativform (1) mit Hilfe eines Rakels mit Dichtungsmaterial gefüllt wird.
